# EUROPÄISCHE PATENTANMELDUNG

(11) **EP 4 249 859 A2**
(43) Veröffentlichungstag der Anmeldung: **27.09.2023**
(21) Anmeldenummer: 23161459.5
(22) Anmeldetag: 13.03.2023
(51) Int. Cl.: G01F 1/66

(54) **ULTRASCHALLWANDLER**

(30) Priorität: 25.03.2022 DE 102022107092
(71) Anmelder: Krohne AG, 4019 Basel (CH)
(72) Erfinder: Schipper, Willemijn, 3353 VA Papendrecht (NL)
(74) Vertreter: Gesthuysen Patentanwälte

(57) **Zusammenfassung**

Beschrieben und dargestellt ist ein Ultraschallwandler (1) für ein Ultraschalldurchflussmessgerät, mit wenigstens einem piezoelektrischen Wandlerelement (2), mit einem ersten Halteelement (3) und mit einem zweiten Halteelement (4), wobei das wenigstens eine piezoelektrische Wandlerelement (2) zwischen dem ersten Halteelement (3) und dem zweiten Halteelement (4) angeordnet ist und wobei das erste Halteelement (3), das wenigstens eine piezoelektrische Wandlerelement (2) und das zweite Halteelement (4) entlang einer Längsachse (5) des Ultraschallwandlers (1) hintereinander angeordnet sind, der dadurch gekennzeichnet ist, dass an der dem piezoelektrischen Wandlerelement (2) abgewandten Seite (6) des ersten Halteelements (3) wenigstens ein Vorspannelement (7) vorgesehen ist, dass auf der dem ersten Halteelement (3) abgewandten Seite (8) des Vorspannelements (7) ein Verbindungselement (9) vorgesehen ist, wobei das Verbindungselement (9) zum Vorspannen des Vorspannelements (7) dient und mit dem zweiten Halteelement (4) verbunden ist und dass im vorgespannten Zustand des Vorspannelements (7) eine Kraft derart auf das erste Halteelement (3) und über das Verbindungselement (9) auf das zweite Halteelement (4) wirkt, dass das erste Halteelement (3) und das zweite Halteelement (4) das wenigstens eine piezoelektrische Wandlerelement (2) einspannen.

## Beschreibung

Die Erfindung betrifft einen Ultraschallwandler für ein Ultraschalldurchflussmessgerät, mit wenigstens einem piezoelektrischen Wandlerelement, mit einem ersten Halteelement und mit einem zweiten Halteelement, wobei das wenigstens eine piezoelektrische Wandlerelement zwischen dem ersten Halteelement und dem zweiten Halteelement angeordnet ist und wobei das erste Halteelement, das wenigstens eine piezoelektrische Wandlerelement und das zweite Halteelement entlang einer Längsachse hintereinander angeordnet sind.

Ultraschallwandler der in Rede stehenden Art sind in einer Vielzahl aus dem Stand der Technik bekannt und finden bei der ultraschallbasierten Durchfluss- oder Füllstandsmessung Anwendung. Das Ultraschallsignal wird hierbei durch ein piezoelektrisches Wandlerelement erzeugt.

Bei vielen aus dem Stand der Technik bekannten Ultraschallwandlern wird das piezoelektrische Wandlerelement auf ein Ultraschallfenster, über das die Ultraschallsignale aus dem Ultraschallwandler in das zu vermessende Medium abgestrahlt werden, geklebt oder mit geeigneten Mitteln gegen das Ultraschallfenster gepresst. Ein derartiger Ultraschallwandler ist beispielsweise aus der DE 10 2007 042 663 A1 bekannt.

Bei anderen aus dem Stand der Technik bekannten Ultraschallwandlern weisen die Ultraschallwandler zumindest zwei Halteelemente auf, zwischen denen das piezoelektrische Wandlerelement eingeklemmt ist. Ein derartiger Ultraschallwandler ist beispielsweise aus der Druckschrift EP 1 181 988 A2. Hier wird ein piezoelektrisches Wandlerelement zwischen zwei Halteelementen eingeklemmt, wobei zum Einklemmen eine Spannfeder verwendet wird, die um das piezoelektrische Wandlerelement angeordnet ist und die beiden Halteelemente miteinander verbindet. Jedes Halteelement wird in die Spannfeder eingeschraubt. Nachteilig an einer solchen Ausgestaltung ist, dass die beiden Halteelemente unmittelbar über die Spannfeder akustisch miteinander gekoppelt sind und dass zudem die Form der von dem piezoelektrischen Wandlerelement erzeugten Ultraschallsignale beeinflusst wird.

Entsprechend ist Aufgabe der Erfindung, einen Ultraschallwandler für ein Ultraschalldurchflussmessgerät anzugeben, der die aus dem Stand der Technik bekannten Nachteile minimiert.

Die Aufgabe ist gemäß dem Kennzeichnungsteil des Patentanspruchs 1 zunächst und im Wesentlichen dadurch gelöst, dass an der dem piezoelektrischen Wandlerelement abgewandten Seite des ersten Halteelements wenigstens ein Vorspannelement vorgesehen ist und dass auf der dem ersten Halteelement abgewandten Seite des Vorspannelements ein Verbindungselement vorgesehen ist. Das Verbindungselement dient zum Vorspannen des Vorspannelements und ist zudem mit dem zweiten Halteelement verbunden. Im vorgespannten Zustand des Vorspannelements wirkt eine Kraft derart auf das erste Halteelement und über das Verbindungselement auf das zweite Halteelement, dass das erste Halteelement und das zweite Halteelement das wenigstens eine piezoelektrische Wandlerelement einspannen.

Wenn davon die Rede ist, dass das Verbindungselement auf der dem ersten Halteelement abgewandten Seite des Vorspannelements angeordnet ist, dann ist damit gemeint, wenigstens Bereiche oder Teile des Vorspannelements auf der dem Halteelement abgewandten Seite des Vorspannelements angeordnet sind. Es ist also nicht vorgesehen, dass sich das Verbindungselement ausschließlich auf der dem ersten Halteelement abgewandten Seite des Vorspannelements befindet. Erfindungsgemäß ist aber das Vorspannelement in Richtung der Längsachse des Ultraschallwandlers zwischen dem ersten Halteelement und dem Verbindungselement bzw. Bereichen oder Teilen des Verbindungselements angeordnet. Das Verbindungselement ist erfindungsgemäß mit dem zweiten Halteelement verbunden, sodass sich Teile des Verbindungselements an dem Vorspannelement und an dem ersten Halteelement vorbei oder durch das Vorspannelement und durch das erste Halteelement hindurch bis hin zum zweiten Halteelement erstrecken. Erfindungsgemäß ist vorgesehen, dass das Verbindungselement und das zweite Halteelement miteinander verbunden sind. Hiermit ist gemeint, dass das Verbindungselement und das zweite Halteelement zumindest im zusammenmontierten Zustand des Ultraschallwandlers und insbesondere im vorgespannten Zustand des Vorspannelements miteinander verbunden sind. Mögliche Realisierungen werden im Zusammenhang mit erfindungsgemäßen Ausgestaltungen weiter unten beschrieben.

Das Vorspannen des Vorspannelements durch das Verbindungselement wird dadurch realisiert, dass der Abstand des Vorspannelements in Richtung der Längsachse des Ultraschallwandlers zu dem zweiten Halteelement verringert wird, wodurch das Vorspannelement in Richtung der Längsachse komprimiert wird.

Das Vorspannelement ist im vorgespannten Zustand bestrebt, in den entspannten Zustand überzugehen, wodurch es eine Kraft sowohl auf das Verbindungselement als auch auf das erste Halteelement ausübt. Die beiden Kräfte sind ihrem Betrag nach gleich, wirken jedoch in entgegengesetzte Richtungen. Durch das Verbindungselement wird die auf das Verbindungselement wirkende Kraft auf das zweite Halteelement übertragen, sodass die Kraft auch auf das zweite Halteelement wirkt. Im Ergebnis spannen das erste Halteelement und das zweite Halteelement das piezoelektrische Wandlerelement zwischen sich ein. Das Maß des Einspannens ist hierbei abhängig vom Maß der Vorspannung des Vorspannelements.

Vorteilhaft an der erfindungsgemäßen Realisierung des Ultraschallwandlers ist, dass alle funktionsnotwendigen Bauteile entlang der Längsachse des Ultraschallwandlers angeordnet sind. Insbesondere dadurch, dass das Vorspannelement nicht unmittelbar im Bereich des piezoelektrischen Wandlerelements angeordnet ist, sondern weit beabstandet von dem piezoelektrischen Wandlerelement angeordnet ist, wird die Beeinflussung der Form der abgestrahlten Ultraschallsignale durch das Vorspannelement erheblich reduziert.

Zur Ausgestaltung des Vorspannelements gibt es erfindungsgemäß verschiedene Möglichkeiten. In einer besonders bevorzugten Ausgestaltung des erfindungsgemäßen Ultraschallwandlers ist vorgesehen, dass das Vorspannelement in dem ersten Halteelement ausgebildet ist. Dies wird beispielsweise dadurch reduziert, dass das Vorspannelement durch eine Materialreduzierung eines Teils des ersten Halteelements oder eine besondere Ausformung eines Teils des ersten Halteelements realisiert ist. Somit wird ein federnder Abschnitt in dem Halteelement realisiert. Der federnde Abschnitt ist an der dem piezoelektrischen Wandlerelement abgewandten Seite des ersten Halteelements ausgebildet.

In einer weiteren bevorzugten Ausführungsform ist das Vorspannelement als ein separates Federelement ausgebildet. Hierzu eignen sich sämtliche aus dem Stand der Technik bekannten Arten von Federelementen, beispielsweise Druckfedern, Scheibenfedern, Wellenfedern oder Tellerfedern.

Besonders bevorzugt ist ebenfalls eine Variante, in der ein zweites Vorspannelement vorgesehen ist. Das zweite Vorspannelement ist bevorzugt in Richtung der Längsachse des Ultraschallwandlers benachbart zu dem ersten Vorspannelement angeordnet. Wenn es heißt, dass das erste Vorspannelement und das zweite Vorspannelement benachbart zueinander angeordnet sind, dann kann dies dadurch realisiert sein, dass die beiden Vorspannelemente unmittelbar nebeneinander angeordnet sind, insbesondere in berührendem Kontakt stehen. Es ist aber auch möglich, dass die beiden Vorspannelemente beabstandet zueinander nebeneinander angeordnet sind, also ein Zwischenraum zwischen den beiden Vorspannelementen existiert. Besonders bevorzugt sind beide Vorspannelemente identisch ausgebildet.

Erfindungsgemäß ist vorgesehen, dass das Verbindungselement zum Vorspannen des Vorspannelements dient. Zugleich ist das Verbindungselement mit dem zweiten Halteelement verbunden. Es gibt nun verschiedene Möglichkeiten, das Verbindungselement zu realisieren.

In einer besonders bevorzugten Ausgestaltung ist das Verbindungselement durch eine Hülse realisiert. In einer Variante ist die Hülse mit einer geschlossenen Oberfläche realisiert. In einer alternativen Variante weist die Hülse Ausnehmungen in ihrer Oberfläche, insbesondere in ihrer Mantelfläche auf.

Zur Befestigung der Hülse mit dem zweiten Halteelement ist in einer ersten Variante vorgesehen, die Hülse über zusätzliche Befestigungselemente mit dem zweiten Halteelement zu verbinden. Diese zusätzlichen Befestigungselemente sind in einer Variante als Rastelemente ausgebildet. Hierzu ist in der Hülse eine Rastausnehmung vorgesehen, in dem zweiten Halteelement ist ein korrespondierender Rastvorsprung ausgebildet. Dies kann in einer weiteren Ausgestaltung auch umgekehrt realisiert sein, sodass die Rastausnehmung in dem zweiten Halteelement und der Rastvorsprung in der Hülse realisiert ist.

In einer weiteren Variante sind die zusätzlichen Befestigungselemente als Schrauben realisiert. Bevorzugt weisen dann die Hülse und das zweite Halteelement entsprechende Ausnehmungen mit einem zu dem Gewinde der Schraube korrespondierenden Gegengewinde auf, so dass die Schrauben in die Ausnehmungen eingeschraubt werden können und so die Hülse befestigen. Da das Verbindungselement zum Vorspannen des Vorspannelements ausgebildet ist, muss die Hülse derart aufgesetzt werden, dass sie das Vorspannelement vorspannt. Somit umschließt die Hülse das Vorspannelement sowie das erste Halteelement und das piezoelektrische Wandlerelement.

Um eine Feinjustierung der Vorspannung des Vorspannelements realisieren zu können, zeichnet sich eine besonders bevorzugte Variante des erfindungsgemäßen Ultraschallwandlers dadurch aus, dass die Hülse auf das zweite Halteelement aufschraubbar ausgebildet ist. Hierzu weist bevorzugt die Hülse an ihrem dem zweiten Halteelement zugewandten Ende ein Innengewinde auf und das zweite Halteelement weist bevorzugt ein korrespondierendes Gegengewinde auf. Je nachdem, wie weit die Hülse auf das zweite Halteelement aufgeschraubt wird, wird das Vorspannelement mehr oder weniger vorgespannt.

In einer alternativen Ausgestaltung des erfindungsgemäßen Ultraschallwandlers, mit der ebenfalls eine Feinjustierung der Vorspannung des Vorspannelements realisiert werden kann, ist dadurch charakterisiert, dass das Verbindungselement T-förmig mit einem T-Dach und einem T-Stab ausgebildet ist. Das T-förmige Verbindungselement weist an seinem dem T-Dach abgewandten Ende des T-Stabs ein Gewinde auf. Das zweite Halteelement weist eine Verbindungselementaufnahme mit einem korrespondierenden Gegengewinde auf. Zudem ist bei dieser Ausgestaltung des erfindungsgemäßen Ultraschallwandlers realisiert, dass das Vorspannelement, das erste Halteelement und das wenigstens eine piezoelektrische Wandlerelement jeweils eine Ausnehmung aufweisen, durch die der T-Stab des T-förmigen Verbindungselements durchgeführt ist. Das Vorspannelement wird dann durch das Einschrauben des T-förmigen Verbindungselements in das zweite Halteelement in den vorgespannten Zustand verbracht. Je nachdem, wie weit das Verbindungselement in das zweite Halteelement eingeschraubt wird, kann die Vorspannung des Vorspannungselements eingestellt werden.

Zur Realisierung des T-Dachs des T-förmigen Verbindungselements sind verschiedene Varianten vorgesehen. In einer ersten Variante ist das T-Dach als geschlossene Scheibe ausgestaltet. In einer alternativen Variante ist das T-Dach durch eine Ausnehmungen aufweisende Scheibe realisiert. Bei sämtlichen Varianten ist das T-Dach derart ausgestaltet, dass ein gleichmäßiges Vorspannen des Vorspannelements realisiert wird.

In einer alternativen Variante ist das Verbindungselement durch einen Verbindungsstab und eine Mutter realisiert. Der Verbindungsstab ist mit dem zweiten Halteelement verbunden. Bei einer derartigen Ausgestaltung weisen das Vorspannelement, das erste Halteelement und das wenigstens eine piezoelektrische Wandlerelement ebenfalls jeweils eine Ausnehmung auf, durch die der Verbindungsstab geführt ist. Der Verbindungsstab weist an seinem dem zweiten Halteelement abgewandten Ende ein Gewinde auf, auf das die Mutter aufschraubbar ist. Durch das Aufschrauben der Mutter auf den Gewindestab wird das Vorspannelement in den vorgespannten Zustand verbracht. Das Maß der Vorspannung kann hier ebenfalls feinjustiert eingestellt werden durch das Maß des Aufschraubens der Mutter auf den Verbindungsstab.

Wie ausgeführt, ist der Verbindungsstab mit dem zweiten Halteelement verbunden. In einer ersten Variante ist der Verbindungsstab unlösbar mit dem zweiten Halteelement verbunden. Dies ist beispielsweise dadurch realisiert, dass der Verbindungsstab und das zweite Halteelement miteinander verschweißt sind. In einer alternativen Ausgestaltung sind der Verbindungsstab und das zweite Halteelement einstückig gefertigt, also aus einem einzigen Werkstück herausgefertigt. Wenn von einer unlösbaren Verbindung die Rede ist, dann ist damit gemeint, dass die Verbindung nicht ohne Zerstörung der Anordnung lösbar ist, insbesondere, dass es besonderer Kraftanstrengung bedarf, um die Verbindung zu lösen.

In einer alternativen Variante ist die Verbindung zwischen dem zweiten Halteelement und dem Verbindungselement lösbar ausgestaltet. Hierbei ist in einer Variante vorgesehen, dass der Verbindungsstab an seinem dem zweiten Halteelement zugewandten Ende ein Gewinde aufweist und dass das zweite Halteelement eine Ausnehmung mit einem Gegengewinde aufweist, sodass der Verbindungsstab in das Halteelement einschraubbar ist. In einer alternativen Variante sind das Halteelement und der Verbindungsstab durch einen Bajonettverschluss miteinander verbunden. In einer dritten Variante sind der Verbindungsstab und das zweite Halteelement durch eine Rastverbindung miteinander verbunden.

Im Einzelnen gibt es nun eine Vielzahl von Möglichkeiten, den erfindungsgemäßen Ultraschallwandler auszugestalten und weiterzubilden. Hierzu wird verwiesen auf die dem unabhängigen Patentanspruch 1 untergeordneten Patentansprüche sowie auf die Beschreibung besonders bevorzugter Ausführungsformen in Verbindung mit der Zeichnung. In der Zeichnung zeigen
- Fig. 1: eine äußere Ansicht einer ersten Variante eines Ultraschallwandlers,
- Fig. 2: eine Schnittdarstellung des in Fig. 1 dargestellten Ultraschallwandlers,
- Fig. 3: ein Schnitt durch das erste Halteelement des in Fig. 2 dargestellten Ultraschallwandlers,
- Fig. 4: eine Schnittdarstellung einer zweiten Variante eines Ultraschallwandlers,
- Fig. 5: eine Schnittdarstellung einer dritten Variante eines Ultraschallwandlers,
- Fig. 6: eine Schnittdarstellung einer vierten Variante eines Ultraschallwandlers und
- Fig. 7: eine Schnittdarstellung einer fünften Variante eines Ultraschallwandlers.

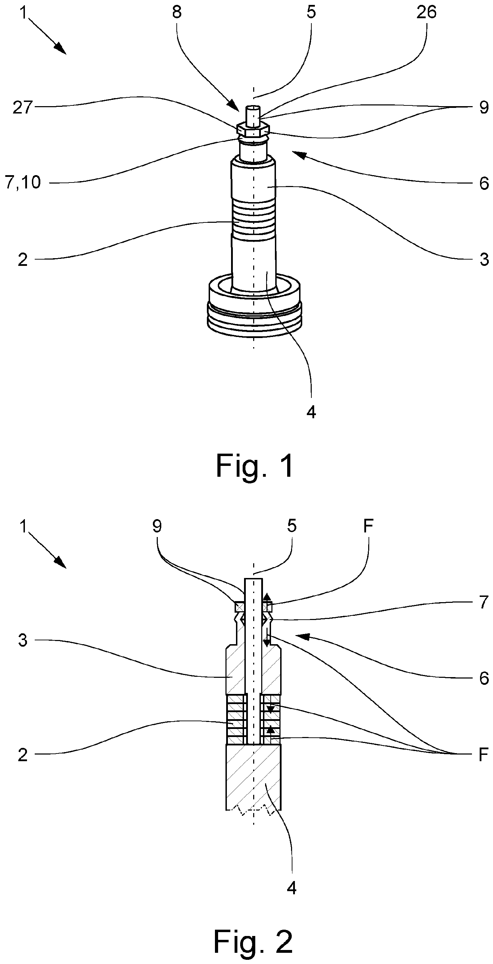

Fig. 1 zeigt eine äußere Ansicht eines Ultraschallwandlers 1 für ein Ultraschalldurchflussmessgerät. Der Ultraschallwandler 1 weist wenigstens ein piezoelektrisches Wandlerelement 2 auf. In der dargestellten Ausführungsform weist der Ultraschallwandler 1 insgesamt sechs piezoelektrische Wandlerelemente 2 auf. Zudem weist der Ultraschallwandler 1 ein erstes Halteelement 3 und ein zweites Halteelement 4 auf, wobei die piezoelektrischen Wandlerelemente 2 zwischen dem ersten Halteelement 3 und dem zweiten Halteelement 4 angeordnet sind. Das erste Halteelement 3, die piezoelektrischen Wandlerelemente 2 und das zweite Halteelement 4 sind entlang einer Längsachse 5 des Ultraschallwandlers 2 hintereinander angeordnet. An seiner dem piezoelektrischen Wandlerelementen 2 abgewandten Seite 6 weist das erste Halteelement 3 ein Vorspannelement 7 auf. Auf der dem ersten Halteelement 3 abgewandten Seite 8 des Vorspannelements 7 ist ein Verbindungselement 9 vorgesehen. Das Verbindungselement 9 dient zum Vorspannen des Vorspannelementes 7 und ist mit dem zweiten Halteelement 4 verbunden. Die Verbindung des Verbindungselements 9 und des zweiten Halteelements 4 ist in Fig. 1 nichtsichtbar, jedoch in der in Fig. 2 dargestellten Schnittdarstellung durch den Ultraschallwandler der Fig. 1 ersichtlich.

Fig. 2 zeigt eine Schnittdarstellung durch den Ultraschallwandler 1 der Fig. 1. Das Vorspannelement 7 wird durch das Verbindungselement 9 vorgespannt. Im vorgespannten Zustand, der in Fig. 2 dargestellt ist, wirkt eine Kraft F derart auf das erste Halteelement 3 und über das Verbindungselement 9 auf das zweite Halteelement 4, dass das erste Halteelement 3 und das zweite Halteelement 4 die piezoelektrischen Wandlerelemente 2 einspannen. In Fig. 2 sind die wirkenden Kräfte durch Kraftpfeile kenntlich gemacht. Dadurch, dass das Vorspannelement 7 bestrebt ist, in seinen entspannten Zustand überzugehen, wirkt eine Kraft F auf das Verbindungselement 9. Eine entgegengesetzte Kraft F wirkt auf das erste Halteelement 3. Die auf das Verbindungselement 9 wirkende Kraft wird aufgrund der Verbindung des Verbindungselements 9 und des zweiten Halteelements 4 auf das zweite Halteelement 4 übertragen. Im Bereich der piezoelektrischen Wandlerelemente 2 wirkt somit eine Kraft F auf das zweite Wandlerelement, die bestrebt ist, das Wandlerelement nach oben zu ziehen und eine entgegengesetzte Kraft F auf das zweite Halteelement 3, die bestrebt ist das Halteelement 3 nach unten zu ziehen. Entsprechend werden die piezoelektrischen Wandlerelemente 2 zwischen dem ersten Halteelement 3 und dem zweiten Halteelement 4 eingeklemmt.

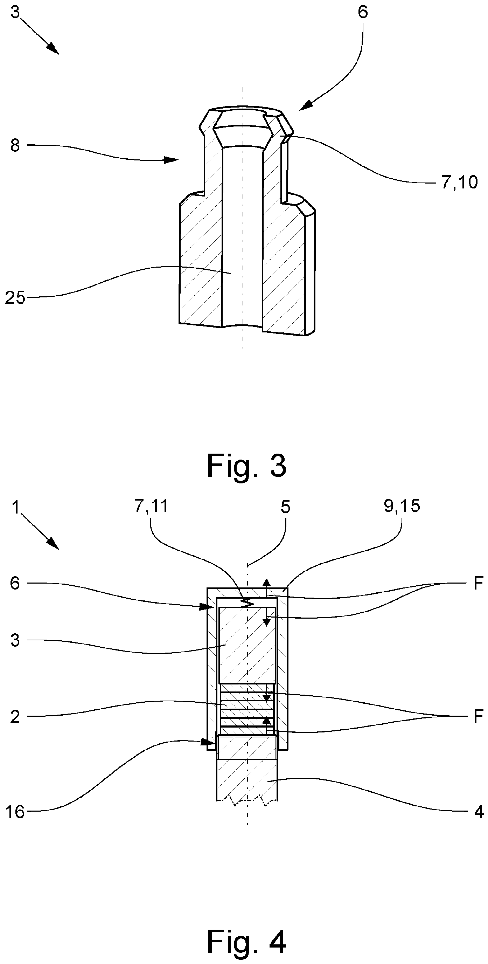

In der dargestellten Ausgestaltung der Fig. 2 ist das Vorspannelement 7 in dem ersten Halteelement 3 ausgebildet. Das erste Halteelement 3 der Fig. 2 ist ebenfalls in Schnittdarstellung in Fig. 3 dargestellt. Das erste Halteelement 3 ist insgesamt zylindrisch ausgestaltet. In seinem oberen Bereich, nämlich an der den piezoelektrischen Wandlerelementen 2 abgewandten Seite 6, weist das zweite Halteelement 4 eine Materialreduzierung auf. Hierdurch wird ein Vorspannelement 7 in Form eines Federelementes realisiert. Die Wandstärke des ersten Halteelements 3 ist in dem oberen Bereich 6 deutlich reduziert und das erste Halteelement 3 in diesem oberen Bereich 6 in Längsrichtung 5 des Ultraschallwandlers 1 komprimierbar.

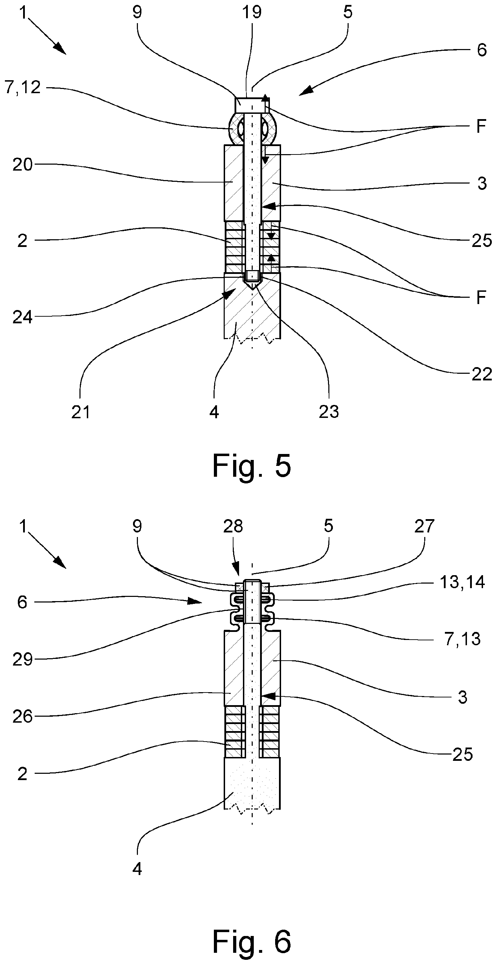

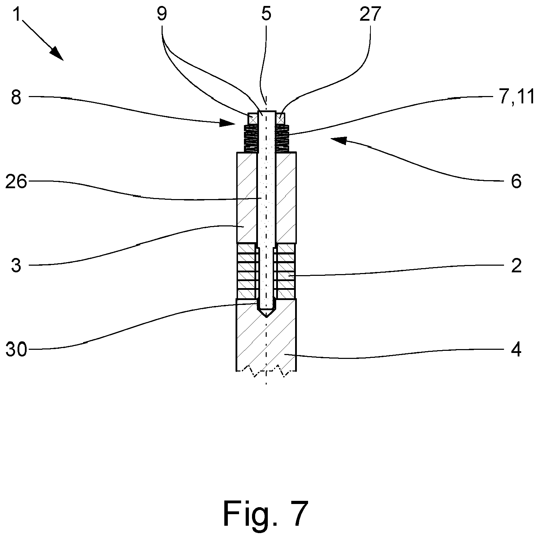

In den weiteren Figuren sind die Vorspannelemente 7 in alternativen Ausgestaltungen dargestellt. In Fig. 7 ist das Vorspannelement 7 beispielsweise durch eine Druckfeder 11 realisiert. In Fig. 5 ist das Vorspannelement 7 als Scheibenfeder 12 realisiert. Fig. 6 zeigt eine Darstellung, in der das Vorspannelement 7 als Tellerfeder 13 ausgebildet ist. In Fig. 6 ist zudem dargestellt, dass der Ultraschallwandler 1 ein zweites Vorspannelement 14 aufweist. Dieses Vorspannelement 14 ist ebenfalls als Tellerfeder 13 realisiert. Das erste Vorspannelement 7 und das zweite Vorspannelement 14 sind benachbart zueinander, jedoch beabstandet voneinander angeordnet, und zwar entlang der Längsachse 5 des Ultraschallwandlers 1.

In den Figuren sind zudem verschiedene Ausgestaltungen des Verbindungselements 9 dargestellt. Bei der Ausführungsform in Fig. 4 ist das Verbindungselement 9 durch eine Hülse 15 realisiert. Die Hülse 15 ist über eine Schraubverbindung 16 mit dem zweiten Halteelement 4 verbunden. Hierzu ist an der Hülse 15 ein Innengewinde 17 ausgebildet und an dem zweiten Halteelement 4 ein korrespondierendes Außengewinde 18 ausgebildet. Die Hülse 15 wird auf das zweite Halteelement 4 aufgeschraubt. Durch das Aufschrauben wird das Vorspannelement 7, das in der dargestellten Ausgestaltung als Druckfeder 11 realisiert ist, komprimiert. In alternativen nicht dargestellten Ausgestaltungen kann die Hülse 15 auf das zweite Halteelement aufgerastet werden oder beispielsweise mit zusätzlichen Befestigungselementen in Form von Schrauben mit dem zweiten Halteelement verbunden werden.

Fig. 5 zeigt eine weitere Ausgestaltung eines Ultraschallwandlers 1 mit einem alternativen Verbindungselements 9. In der dargestellten Ausgestaltung ist das Verbindungselement 9 T-förmig realisiert und weist ein T-Dach 19 und einen T-Stab 20 auf. An seinem dem T-Dach 19 abgewandten Ende 21 ist an dem T-Stab 20 ein Gewinde 22 ausgebildet. Das zweite Halteelement 4 weist eine Verbindungselementaufnahme 23 mit einem korrespondierenden Gegengewinde 24 auf, sodass der T-Stab 20 in die Verbindungselementaufnahme 23 eingeschraubt werden kann. Sowohl das Vorspannelement 7 als auch das erste Halteelement 3 und die piezoelektrischen Wandlerelemente 2 weisen jeweils eine Ausnehmung 25 auf, durch die der T-Stab 20 des T-förmigen Verbindungselements 9 durchgeführt ist. Durch das Einschrauben des T-förmigen Verbindungselements 9 in das zweite Halteelement 4 wird das Vorspannelement 7 in den vorgespannten Zustand verbracht.

Weitere Ausgestaltungen des Verbindungselements 9 sind in Fig. 6 und Fig. 7 realisiert. In Fig. 6 und auch in Fig. 7 ist das Verbindungselement 9 durch einen Verbindungsstab 26 und eine Mutter 27 realisiert. Der Verbindungsstab 26 ist mit dem zweiten Halteelement 4 verbunden. Auch in dieser Ausgestaltung weisen das Vorspannelement 7, das erste Halteelement 3 und die piezoelektrischen Wandlerelemente 2 jeweils eine Ausnehmung 25 auf, durch die der Verbindungsstab 26 geführt ist. Der Verbindungsstab 26 weist an seinem dem zweiten Halteelement 4 abgewandten Ende 28 ein Gewinde 29 auf, auf das die Mutter 27 aufschraubbar ist. Durch das Aufschrauben der Mutter 27 auf den Verbindungsstab 26 wird das Vorspannelement 7 bzw. bei der in Fig. 6 dargestellten Ausgestaltung die Vorspannelemente 7 und 14, in den vorgespannten Zustand verbracht.

In Fig. 6 ist der Verbindungsstab 26 unlösbar mit dem zweiten Halteelement 4 verbunden, nämlich in der Darstellung einstückig mit dem zweiten Verbindungselement 4 ausgebildet. Im Gegensatz dazu ist bei der Darstellung der Fig. 7 der Verbindungsstab 26 lösbar mit dem zweiten Halteelement 4 verbunden. Dies wird im dargestellten Beispiel durch eine Schraubverbindung 30 realisiert. Weitere nicht dargestellte Möglichkeiten sind beispielsweise Rastverbindungen oder Bajonettverbindungen.

### Bezugszeichen

- 1: Ultraschallwandler
- 2: piezoelektrisches Wandlerelement
- 3: erstes Halteelement
- 4: zweites Halteelement
- 5: Längsachse
- 6: dem Wandlerelement abgewandten Seite des ersten Halteelements
- 7: Vorspannelement
- 8: dem ersten Halteelement abgewandten Seite des Vorspannelements
- 9: Verbindungselement
- 10: Federelement
- 11: Druckfeder
- 12: Scheibenfeder
- 13: Tellerfeder
- 14: zweites Vorspannelement
- 15: Hülse
- 16: Schraubverbindung
- 17: Innengewinde
- 18: Außengewinde
- 19: T-Dach
- 20: T-Stab
- 21: dem T-Dach abgewandtes Ende des T-Stabs
- 22: Gewinde
- 23: Verbindungselementaufnahme
- 24: Gegengewinde
- 25: Ausnehmung
- 26: Verbindungsstab
- 27: Mutter
- 28: dem zweiten Halteelement abgewandtes Ende des Verbindungsstabs
- 29: Gewinde
- 30: Schraubverbindung

## Patentansprüche

1. Ultraschallwandler (1) für ein Ultraschalldurchflussmessgerät, mit wenigstens einem piezoelektrischen Wandlerelement (2), mit einem ersten Halteelement (3) und mit einem zweiten Halteelement (4), wobei das wenigstens eine piezoelektrische Wandlerelement (2) zwischen dem ersten Halteelement (3) und dem zweiten Halteelement (4) angeordnet ist und wobei das erste Halteelement (3), das wenigstens eine piezoelektrische Wandlerelement (2) und das zweite Halteelement (4) entlang einer Längsachse (5) des Ultraschallwandlers (1) hintereinander angeordnet sind,
**dadurch gekennzeichnet,**
**dass** an der dem piezoelektrischen Wandlerelement (2) abgewandten Seite (6) des ersten Halteelements (3) wenigstens ein Vorspannelement (7) vorgesehen ist,
**dass** auf der dem ersten Halteelement (3) abgewandten Seite (8) des Vorspannelements (7) ein Verbindungselement (9) vorgesehen ist, wobei das Verbindungselement (9) zum Vorspannen des Vorspannelements (7) dient und mit dem zweiten Halteelement (4) verbunden ist,
**dass** im vorgespannten Zustand des Vorspannelements (7) eine Kraft derart auf das erste Halteelement (3) und über das Verbindungselement (9) auf das zweite Halteelement (4) wirkt, dass das erste Halteelement (3) und das zweite Halteelement (4) das wenigstens eine piezoelektrische Wandlerelement (2) einspannen.

2. Ultraschallwandler (1) nach Anspruch 1, **dadurch gekennzeichnet, dass** das Vorspannelement (7) in dem ersten Halteelement (3) ausgebildet ist, insbesondere dass das Vorspannelement (7) durch eine Materialreduzierung des ersten Halteelements (3) realisiert ist.

3. Ultraschallwandler (1) nach Anspruch 1, **dadurch gekennzeichnet, dass** das Vorspannelement (7) als separates Federelement (10) ausgebildet ist, insbesondere als Druckfeder (11), Scheibenfeder (12), Wellenfeder oder Tellerfeder (13).

4. Ultraschallwandler (1) nach einem der Ansprüche 1 bis 3, **dadurch gekennzeichnet, dass** wenigstens ein zweites Vorspannelement (14) vorgesehen ist, wobei das erste Vorspannelement (7) und das zweite Vorspannelement (14) in Richtung der Längsachse (5) des Ultraschallwandlers (1) benachbart zueinander angeordnet sind, insbesondere wobei das erste Vorspannelement (7) und das zweite Vorspannelement (14) gleich ausgebildet sind.

5. Ultraschallwandler (1) nach einem der Ansprüche 1 bis 4, **dadurch gekennzeichnet, dass** das Verbindungselement (9) durch eine Hülse (15) realisiert ist, insbesondere dass die Hülse (15) über zusätzliche Befestigungselemente mit dem zweiten Halteelement (4) verbindbar ist oder dass die Hülse (15) auf das zweite Halteelement (4) aufschraubbar ist, sodass durch das Verrasten oder durch das Aufschrauben der Hülse (15) das Vorspannelement (7) in den vorgespannten Zustand verbracht wird.

6. Ultraschallwandler (1) nach einem der Ansprüche 1 bis 4, **dadurch gekennzeichnet, dass** das Verbindungselement (9) T-förmig mit einem T-Dach (19) und einem T-Stab (20) ausgebildet ist, wobei das T-förmige Verbindungselement (9) an seinem dem T-Dach (20) abgewandten Ende (21) des T-Stabs (19) ein Gewinde (22) aufweist, dass das zweite Halteelement (4) eine Verbindungselementaufnahme (23) mit einem korrespondierenden Gegengewinde (24) aufweist, dass das Vorspannelement (7), das erste Halteelement (3) und das wenigstens eine piezoelektrische Wandlerelement (2) jeweils eine Ausnehmung (25) aufweisen, durch die der T-Stab (20) des T-förmigen Verbindungselements (9) durchgeführt ist und dass das Vorspannelement (7) durch das Einschrauben des T-förmigen Verbindungselements (9) in das zweite Halteelement (4) in den vorgespannten Zustand verbracht wird.

7. Ultraschallwandler (1) nach einem der Ansprüche 1 bis 4, **dadurch gekennzeichnet, dass** das Verbindungselement (9) durch einen Verbindungsstab (26) und eine Mutter (27) realisiert ist, dass der Verbindungsstab (26) mit dem zweiten Halteelement (4) verbunden ist, dass das Vorspannelement (7), das erste Halteelement (3) und das wenigstens eine piezoelektrische Wandlerelement (2) jeweils eine Ausnehmung (26) aufweisen, durch die der Verbindungsstab (26) durchgeführt ist, dass der Verbindungsstab (26) an seinem dem zweiten Halteelement (4) abgewandten Ende (28) ein Gewinde (29) aufweist, auf das die Mutter (27) aufschraubbar ist und dass das Vorspannelement (7) durch das Aufschrauben der Mutter (28) auf den Verbindungsstab (26) in den vorgespannten Zustand verbracht wird.

8. Ultraschallwandler (1) nach Anspruch 7, **dadurch gekennzeichnet, dass** der Verbindungsstab (26) unlösbar mit dem zweiten Halteelement (4) verbunden ist, insbesondere mit dem zweiten Halteelement (4) verschweißt ist oder einstückig mit dem zweiten Halteelement (4) ausgebildet ist.

9. Ultraschallwandler (1) nach Anspruch 7, **dadurch gekennzeichnet, dass** der Verbindungsstab (26) lösbar mit dem zweiten Halteelement (4) verbunden ist, insbesondere durch eine Schraubverbindung (30), eine Rastverbindung oder eine Bajonettverbindung.
